(19) Europäisches Patentamt / European Patent Office / Office européen des brevets

(11) **EP 2 607 911 B1**

(12) **FASCICULE DE BREVET EUROPEEN**

(45) Date de publication et mention de la délivrance du brevet:
**03.03.2021 Bulletin 2021/09**

(21) Numéro de dépôt: **12198663.2**

(22) Date de dépôt: **20.12.2012**

(51) Int Cl.:
*G01R 31/392* (2019.01)    *G01R 31/389* (2019.01)
*G01R 31/00* (2006.01)    *G01R 27/02* (2006.01)
*G01R 27/28* (2006.01)    *G01N 27/02* (2006.01)
*H01M 10/42* (2006.01)

(54) **Méthode de détermination d'un paramètre d'état d'un élément électrochimique par impédance complexe aux fréquences radioéléctriques**

Bestimmungsmethode eines Zustandsparameters eines elektrochemischen Elements mit Hilfe der komplexen Impedanz der Funkfrequenzen

Method for determining a status parameter of an electrochemical element by complex impedance with radio frequencies

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.12.2011 FR 1162421**

(43) Date de publication de la demande:
**26.06.2013 Bulletin 2013/26**

(73) Titulaire: **SAFT**
**93170 Bagnolet (FR)**

(72) Inventeurs:
• **Patin, Alain**
  **33320 Le Taillan Medoc (FR)**
• **Fleureau, Patrice**
  **33320 Le Taillan Medoc (FR)**
• **Desprez, Philippe**
  **33320 Le Taillan Medoc (FR)**
• **Reboussin, Loïc**
  **33320 Eysines (FR)**

(74) Mandataire: **Hirsch & Associés**
**154 Boulevard Haussmann**
**75008 Paris (FR)**

(56) Documents cités:
EP-A2- 0 388 099    WO-A1-2012/168066
DE-A1-102009 009 954    DE-A1-102009 018 079
FR-A1- 2 737 923    US-A1- 2006 284 617
US-A1- 2007 188 177    US-A1- 2011 074 432

• **HOMBRADOS A G ET AL: "Symmetrical electrode mode for PEMFC characterisation using impedance spectroscopy", JOURNAL OF POWER SOURCES, ELSEVIER SA, CH, vol. 151, 10 October 2005 (2005-10-10), pages 25-31, XP027756630, ISSN: 0378-7753 [retrieved on 2005-10-10]**

**Description**

DOMAINE TECHNIQUE

L'invention se rapporte au domaine technique des méthodes non destructives de caractérisation des paramètres physico-chimiques d'un élément électrochimique.

ETAT DE LA TECHNIQUE

Un élément électrochimique, également désigné dans ce qui suit par le terme « élément », est un dispositif de production d'électricité dans lequel de l'énergie chimique est convertie en énergie électrique. L'énergie chimique est constituée par des composés électrochimiquement actifs déposés sur au moins une face de feuillards métalliques. L'énergie électrique est produite par des réactions électrochimiques au cours d'une décharge de l'élément. Des électrodes, disposées dans un conteneur, sont connectées électriquement à des bornes de sortie de courant qui assurent une continuité électrique entre les électrodes et un consommateur électrique auquel l'élément est associé. Les électrodes positives et négatives sont séparées par un séparateur qui empêche le contact d'une électrode d'une polarité donnée avec une électrode de polarité opposée. Le séparateur et les électrodes sont imbibés d'un électrolyte. L'électrolyte permet la migration des ions entre les électrodes.

Les causes de vieillissement d'un élément électrochimique sont diverses. Le vieillissement peut être dû à une corrosion des électrodes, à une perte d'adhérence des composés électrochimiquement actifs au feuillard métallique collecteur de courant, à une diminution de la quantité d'électrolyte, à un assèchement du séparateur, etc.

Le vieillissement peut être détecté par la mesure de la résistance interne de l'élément. En effet, celle-ci augmente progressivement au cours de la vie de l'élément. On peut fixer pour un type d'élément donné, une valeur seuil de résistance interne au-delà de laquelle on considère que l'élément est arrivé en fin de vie. La résistance interne R d'un élément peut être mesurée en provoquant par exemple une décharge de l'élément à un courant I et en mesurant la chute de tension $\Delta U$ à ses bornes. La résistance interne est obtenue en appliquant la relation R= $\Delta U/I$. Cette technique non destructive permet de mesurer la résistance totale de l'élément mais ne permet pas de déterminer si l'augmentation de la résistance est due à une dégradation des électrodes ou à une dégradation de l'électrolyte.

Il est aussi connu d'utiliser la spectroscopie d'impédance pour suivre l'augmentation de la résistance interne d'un élément électrochimique au cours du vieillissement. Cette technique consiste à mesurer la réponse électrique d'un élément lorsque celui-ci est soumis à un courant de forme sinusoïdale ou à une variation de tension sinusoïdale. L'impédance complexe mesurée par cette technique Z=module(Z) exp(i*argument(Z)). Cette technique permet de suivre l'évolution de l'impédance de l'élément qui donne des informations sur son vieillissement.

Un exemple d'analyse par spectroscopie d'impédance est publié dans l'article de HOMBRADOS A G ET AL: "Symmetrical electrode mode for PEMFC characterisation using impedance spectroscopy",JOURNAL OF POWER SOURCES, ELSEVIER SA, CH, vol. 151, 10 octobre 2005 (2005-10-10), pages 25-31, XP027756630, ISSN: 0378-7753. D'autres techniques, non basées sur des signaux électriques sont également connues pour déterminer l'état de l'élément, que ce soit son vieillissement ou son état de charge. Parmi ces méthodes, on peut mentionner la méthode acoustique qui consiste à analyser des ondes de pression issues du fonctionnement de l'élément électrochimique, par exemple dues à l'apparition de gaz. On peut également citer une technique exploitant les variations de susceptibilité magnétique de l'électrolyte et des électrodes en fonction de l'état de charge de l'élément électrochimique. Cette technique permet de déterminer l'état de charge d'un élément à partir de sa susceptibilité magnétique. Le champ magnétique décroit lorsque l'élément est en décharge et augmente lorsque l'élément est en charge. Cette méthode permet une détection précise de l'état de charge dans une plage allant de 40 à 70%. On pourra se référer au site internet: «http://batteryuniversity.com/learn/article/how_to_know_end_of_battery_life».

L'ensemble des méthodes mentionnées ci-dessus donnent une information plus ou moins précise sur l'état de l'élément électrochimique, sur son vieillissement, mais ne donnent pas d'information précise sur la cause et l'origine de ce vieillissement.

Les méthodes actuelles de détermination de l'origine d'une défaillance d'un élément électrochimique nécessitent le démontage de l'élément afin d'effectuer un examen visuel des différents composants de l'élément. Cette technique est d'une part destructrice de l'élément. D'autre part, elle ne permet de connaître rapidement la cause de la défaillance.

On cherche donc une méthode permettant de détecter la présence d'un défaut dans un élément électrochimique issu d'une ligne de fabrication. On recherche également une méthode non destructive permettant de fournir en temps réel des caractéristiques des paramètres physico-chimiques d'un élément électrochimique.

**EP 2 607 911 B1**

## RESUME DE L'INVENTION

A cet effet, l'invention propose une méthode de détermination d'un paramètre d'état d'un élément électrochimique selon la revendication 1.

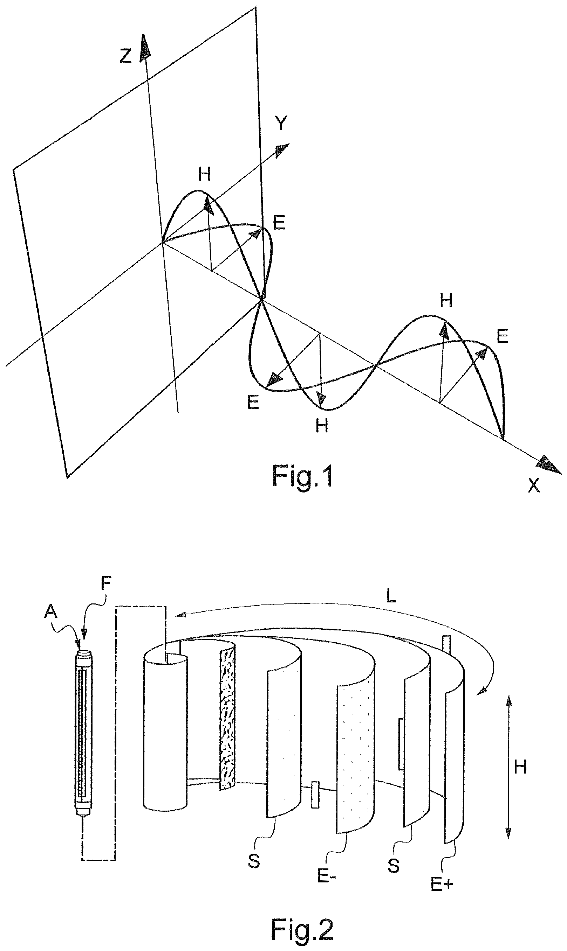

Une onde électromagnétique est un nouveau moyen d'inspection d'un élément électrochimique, de physique différente des méthodes mentionnées ci-dessus. On rappelle qu'une onde électromagnétique est formée de deux composantes : un champ électrique E et un champ magnétique H. Les deux champs sont perpendiculaires l'un à l'autre, leurs amplitudes sont en rapport constant et leurs variations sont en phase. La Figure 1 présente les directions relatives des lignes du champ électrique E, du champ magnétique H et du sens de propagation, représenté par l'axe X, d'une onde électromagnétique. Si l'une des lignes de champ change de sens, la direction de propagation est inversée. Les champs électrique E et magnétique H sont considérés comme variant sinusoïdalement en fonction du temps. On parle d'impédance pour le traitement du signal issu de la propagation de l'onde électromagnétique. Cette impédance complexe est de nature différente de celle d'une impédance électrochimique qui est définie sur un signal électrique, alors que dans la présente invention, elle est relative à la propagation d'une onde électromagnétique.

La méthode selon l'invention permet de déterminer certaines caractéristiques physiques ou chimiques d'un élément électrochimique à partir de l'analyse de l'impédance complexe lorsque celui-ci est soumis à une onde électromagnétique. La méthode selon l'invention comprend l'application à l'élément électrochimique d'un signal dont la fréquence est en rapport avec les dimensions physiques de l'élément. Il permet de déterminer en temps réel de manière non destructive l'état de l'élément électrochimique (vieillissement, état de charge) ainsi que l'origine d'un défaut dans un élément électrochimique, par exemple à l'issue de son procédé de fabrication.

On entend par paramètre d'état une caractéristique physique, physico-chimique, ou chimique d'un constituant de l'élément électrochimique. Une caractéristique physique peut être liée à la géométrie de l'élément et des pièces le constituant, telle que la hauteur ou la longueur du faisceau électrochimique déroulé ou le volume d'électrolyte. Une caractéristique physico-chimique peut être la nature des matériaux actifs, leur composition, leur structure cristallographique, leur granulométrie, ou la nature de la masse active comprenant la matière active, des additifs de percolation et des liants. Une caractéristique chimique peut-être la concentration de sel dissous dans l'électrolyte, le degré d'imbibition (ou d'imprégnation) par l'électrolyte des électrodes ou du séparateur. Ces paramètres d'état incluent donc l'état de l'élément : sa capacité, sa résistance interne, son état de charge, son état de santé, des défauts.

On entend par indicateur de la valeur du paramètre d'état une grandeur physique issue de l'analyse du spectre d'impédance permettant d'en déduire une valeur du paramètre d'état. Ce peut être la fréquence de résonance, la partie réelle, la partie imaginaire ou l'argument de l'impédance complexe.

Selon un mode de réalisation, la fréquence de l'onde électromagnétique va de 100 kHz à 10 GHz, de préférence de 1 MHz à 1 GHz, de préférence encore de 10 MHz à 1 GHz.

Selon un mode de réalisation, la valeur du paramètre d'état est comparée à une valeur de référence et l'élément électrochimique est considéré comme présentant un défaut si l'écart entre la valeur du paramètre d'état et la valeur de référence dépasse un seuil prédéterminé.

Selon un mode de réalisation, la valeur du paramètre d'état est obtenue par comparaison du tracé de la variation de l'indicateur de la valeur du paramètre d'état avec le tracé de la variation de cet indicateur obtenu à partir de la mesure de l'impédance complexe d'un élément électrochimique de référence.

Selon un mode de réalisation, le paramètre d'état est un paramètre qui varie au cours de l'utilisation de l'élément électrochimique, tel que sa capacité, sa résistance interne, son état de charge, l'état de vieillissement des électrodes, l'état de vieillissement de l'électrolyte ou l'état de vieillissement du séparateur.

Selon un mode de réalisation, la méthode comprend les étapes de :

- mesure de l'impédance complexe du faisceau électrochimique;
- tracé du spectre d'impédance complexe du faisceau électrochimique et
- détermination d'au moins une fréquence de résonance $f_0$ du spectre d'impédance complexe, qui est une fréquence à laquelle la partie imaginaire de l'impédance complexe est nulle.

Selon un mode de réalisation, le spectre d'impédance complexe du faisceau électrochimique est tracé pour une plage de fréquences comprises entre 200 MHz et 1GHz, de préférence entre 300 MHz et 600 MHz et dans laquelle plage, il existe au moins une fréquence de résonance $f_0$, de manière à déterminer le paramètre d'état correspondant à la hauteur du faisceau électrochimique.

Selon un mode de réalisation, le spectre d'impédance complexe du faisceau électrochimique est tracé pour une plage de fréquences comprises entre 10 MHz et 200 MHz, de préférence entre 50 MHz et 200 MHz et dans laquelle plage, il existe au moins une fréquence de résonance $f_0$, de manière à déterminer le paramètre d'état correspondant à la longueur du faisceau électrochimique déroulé.

Selon un mode de réalisation, on mesure l'impédance complexe du faisceau électrochimique; on trace la variation pour une fréquence allant de 0,01 MHz à 10 MHz, de préférence de 0,1 MHz à 1 MHz, d'au moins l'un des indicateurs choisis parmi la partie réelle de l'impédance complexe, la partie imaginaire de l'impédance complexe ou une combinaison de celles-ci, telle que l'argument de l'impédance complexe, de manière à déterminer un paramètre d'état, de préférence le vieillissement de l'élément électrochimique.

Selon un mode de réalisation, on compare le tracé de la variation d'au moins un desdits indicateurs par rapport au tracé de la variation du ou des mêmes indicateurs obtenu(s) à partir de la mesure de l'impédance complexe d'un faisceau électrochimique de référence.

Selon un mode de réalisation, on représente la variation de la partie réelle de l'impédance complexe en fonction de la fréquence et il existe au moins un pic tel que le ratio :

$$(Remax - Max\ (Re1, Re2))/Remax$$

soit supérieur à 0,5, de préférence supérieur à 0,75 où

Remax représente la partie réelle au sommet du pic ;
Re1 et Re2 désignent les parties réelles aux deux bases du pic ; et
Max (Re1, Re2) représente la valeur maximum de Re1 et Re2.

Selon un mode de réalisation, on représente la variation de la partie imaginaire de l'impédance complexe en fonction de la fréquence et il existe au moins un pic tel que le ratio :

$$(Immax - Max\ (Im1, Im2))/Immax$$

soit supérieur à 0,5, de préférence supérieur à 0,75 où

Immax représente la partie imaginaire au sommet du pic ;
Im1 et Im2 désignent les parties imaginaires aux deux bases du pic ; et
Max(Im1, Im2) représente la valeur maximum de Im1 et Im2.

Selon un mode de réalisation, l'élément électrochimique est au lithium, de préférence de type lithium-ion.
L'invention a également pour objet une méthode de contrôle de la fabrication d'éléments électrochimiques, mettant en œuvre la méthode de détermination d'un paramètre d'état telle que décrite précédemment, dans laquelle méthode de contrôle:

- on mesure sur chaque élément fabriqué la valeur du paramètre d'état ;
- on rejette un élément lorsque l'écart entre la valeur du paramètre d'état mesurée et une valeur de référence excède un seuil prédéterminé.

Selon un mode de réalisation, la méthode de contrôle comprend un prélèvement statistique d'éléments électrochimiques dans une ligne de fabrication afin de suivre l'évolution des éléments électrochimiques produits.

BREVE DESCRIPTION DES FIGURES

La figure 1 représente schématiquement les composantes du champ électrique E et du champ magnétique H d'une onde électromagnétique.
La figure 2 représente un schéma éclaté montrant les différents constituants d'un faisceau électrochimique.
La figure 3a représente un schéma de principe de l'acquisition des mesures d'impédance dans le cas d'une réflexion d'une onde électromagnétique par le faisceau électrochimique, l'élément électrochimique ne subissant ni charge, ni décharge (circuit ouvert)
La figure 3b représente un schéma de principe de l'acquisition des mesures d'impédance dans le cas d'une réflexion d'une onde électromagnétique par le faisceau électrochimique, l'élément électrochimique étant traversé soit par un courant de charge soit par un courant de décharge (élément sous courant).
La figure 3c représente un schéma de principe de l'acquisition des mesures d'impédance dans le cas d'une transmission d'une onde électromagnétique par le faisceau électrochimique, l'élément électrochimique ne subissant ni charge, ni décharge (circuit ouvert).

La figure 3d représente un schéma de principe de l'acquisition des mesures d'impédance dans le cas d'une transmission d'une onde électromagnétique par le faisceau électrochimique, l'élément électrochimique étant traversé soit par un courant de charge soit par un courant de décharge (élément sous courant).La figure 4 représente la propagation d'une onde électromagnétique selon la direction P à travers une plaque plane de hauteur H et de longueur L.

Les figures 5a et 5b représentent un élément électrochimique simplifié de type « sachet » ou « pouch cell » comprenant une électrode plane positive (E+) et une électrode négative (E-), présentant respectivement un collecteur de courant positif (C+) et un collecteur de courant négatif (C-). Sur la figure 5a, les collecteurs de courant (C+, C-) sont situés sur deux bords opposés des électrodes. Sur la figure 5b, les collecteurs de courant (C+, C-) sont situés sur les mêmes bords des électrodes.

La figure 5c représente un faisceau électrochimique après déroulement des électrodes du faisceau électrochimique. Les collecteurs de courant (C-, C+) sont situés sur le même bord des électrodes.

La figure 6 représente un exemple de la variation de la partie imaginaire de l'impédance complexe pour une fréquence comprise entre 300 et 600 MHz.

La figure 7 représente un exemple de superposition des tracés d'un premier spectre réalisé sur un élément électrochimique de référence a) et d'un second spectre réalisé sur un élément électrochimique à tester b).

La figure 8 représente un exemple de variation de l'argument de l'impédance d'un élément après formation électrochimique a) et après quelques jours de mise au repos b) pour une fréquence allant de 70 à 190 MHz.

La figure 9 représente un exemple de variation de la partie imaginaire de l'impédance de deux éléments électrochimiques caractérisés par des taux d'autodécharge différents. Les fréquences balayées vont de 0,1 à 1,1 MHz : a) élément avec un taux d'autodécharge négligeable ; b) élément avec un taux d'autodécharge significatif.

La figure 10 représente un exemple de variation de la partie réelle de l'impédance de deux éléments électrochimiques caractérisés par des taux d'autodécharge différents. Les fréquences balayées vont de 0,1 à 1,1 MHz : a) élément avec un taux d'autodécharge négligeable ; b) élément avec un taux d'autodécharge significatif.

La figure 11 représente un exemple de variation de l'argument de deux éléments électrochimiques caractérisés par des taux d'autodécharge différents. Les fréquences balayées vont de 0,1 à 1,1 MHz : a) élément avec un taux d'autodécharge négligeable ; b) élément avec un taux d'autodécharge significatif.

## EXPOSE DETAILLE DES MODES DE REALISATION

Selon l'invention, on assimile le faisceau d'un élément électrochimique à une ligne de transmission à travers laquelle une onde électromagnétique est susceptible de se propager. La figure 2 est une vue éclatée d'un faisceau électrochimique. Le faisceau électrochimique (F) est généralement constitué par l'assemblage d'électrodes positives (E+) et négatives (E-) avec un séparateur (S) intercalé entre une électrode positive et une électrode négative.. Les électrodes positives et négatives sont préalablement obtenues par dépôt sur au moins une des faces d'un feuillard métallique d'une composition contenant une matière électrochimiquement active. On assemble au moins une électrode positive, un séparateur et au moins une électrode négative. On enroule cet assemblage autour d'un axe cylindrique (A) qui confère à l'assemblage une forme spiralée pour obtenir le faisceau électrochimique. Le faisceau électrochimique spiralé est introduit dans un conteneur de format cylindrique non représenté. Les dimensions (hauteur H, longueur L, épaisseur) du feuillard de l'électrode positive et celles du feuillard de l'électrode négative sont généralement sensiblement identiques. La hauteur H d'un feuillard est définie comme la plus petite dimension de ce feuillard située dans le plan formé par le feuillard lorsque celui-ci est déroulé. La longueur L d'un feuillard est définie comme la plus grande dimension de ce feuillard située dans le plan formé par le feuillard lorsque celui-ci est déroulé. La hauteur du faisceau électrochimique est égale à la hauteur du feuillard utilisé pour les électrodes positive et négative. Les feuillards utilisés pour les électrodes ont typiquement une hauteur H de l'ordre de 3 à 30 cm et une longueur L pouvant atteindre plusieurs mètres. Dans le cas d'un accumulateur lithium-ion, l'électrode positive comprend un feuillard généralement en aluminium sur lequel est déposé un composé électrochimiquement actif qui peut être un oxyde lithié de métaux de transition ou un phosphate lithié. L'électrode négative comprend un feuillard généralement en cuivre sur lequel est déposé un composé électrochimiquement actif qui peut être un oxyde de vanadium ou un composé carboné, tel que le graphite. Le séparateur est un isolant électrique constitué généralement d'un polymère, tel qu'une polyoléfine.

Chaque électrode constitue une plaque à travers laquelle se propage une onde électromagnétique. On assimile le séparateur imbibé d'électrolyte à un diélectrique pris en sandwich entre la plaque positive et la plaque négative. A l'image d'une antenne traversée par une onde électromagnétique, on assimile le faisceau électrochimique à une ligne de transmission à plaques parallèles ouverte de longueur de longueur L. En raison de l'enroulement serré formé par les électrodes et le séparateur, on considère que les électrodes positives et négatives sont confondues en une seule plaque. Le faisceau électrochimique une fois formé constitue une unique ligne de transmission d'une onde électromagnétique, laquelle ligne possède une longueur L et est ouverte à son extrémité.

Au premier ordre de grandeur, l'impédance complexe Z de cette ligne répond aux équations simplifiées générales des lignes de propagation ouvertes aux fréquences radioélectriques, soit :

$$Z = Re(Z) + jIm(Z) = (R + r(f)) + j(Z_c \times coth(\gamma \times L))$$

où :

R est la résistance interne de l'élément à l'origine de l'effet Joule
r(f) est la résistance haute fréquence due aux connections, résistance dite effet de peau
$Z_c$ est l'impédance caractéristique de la ligne
$\gamma$ est la constante de propagation de la ligne et vaut $2\pi/\lambda$
$\lambda$ désigne la longueur d'onde du signal électromagnétique $\lambda = c/F$
c désigne la vitesse de propagation d'une onde électromagnétique dans vide et vaut $3 \times 10^8$ m.s$^{-1}$
coth ($\gamma \times L$) désigne la cotangente hyperbolique du produit $\gamma \times L$
L désigne la longeur de la ligne à travers laquelle se propage l'onde électromagnétique
j désigne l'opérateur imaginaire

Les paramètres d'état susceptibles d'être déterminés par l'invention sont ceux qui ont une influence sur l'impédance du faisceau électrochimique. Ils peuvent être :

- une dimension d'un des constituants du faisceau électrochimique : on peut par exemple choisir les dimensions des feuillards métalliques, telles que leur longueur ou leur hauteur ;
- indicatifs d'un état de vieillissement d'une électrode : on peut citer, dans le cas d'un accumulateur au lithium, la formation d'un dépôt de lithium métallique à la surface de l'électrode négative entrainant un vieillissement de l'électrode. On peut également citer une mauvaise percolation de l'électrode.
- indicatifs de la quantité de matière active positive et négative déposée à la surface des feuillards collecteurs de courant positifs et négatifs respectivement : la méthode selon l'invention permet par exemple de détecter le vieillissement d'une électrode dû à une perte d'adhérence de matière active sur la surface du collecteur de courant. Elle permet de détecter des sources de non-homogénéité du processus d'enduction d'un feuillard par de la matière active.
- indicatifs d'une modification du séparateur : le degré de diffusion de l'électrolyte dans les pores du séparateur, donc le taux d'imprégnation du séparateur par l'électrolyte influence l'impédance de l'élément électrochimique. La méthode selon l'invention permet par exemple de détecter un assèchement du séparateur par consommation d'électrolyte au cours du fonctionnement de l'élément électrochimique. Un assèchement du séparateur entraîne une hausse de la résistance interne de l'élément électrochimique. La méthode permet également de détecter la présence de micro courts-circuits résultant de micro déchirures du séparateur.
- indicatifs de la quantité d'électrolyte et de la concentration de sel dans l'électrolyte.

L'exploitation du spectre d'impédance complexe permet dans un premier temps de déterminer un indicateur de la valeur du paramètre d'état. Dans un second temps, on déduit à partir de l'indicateur, la valeur du paramètre d'état. Comme expliqué ci-avant, l'indicateur de la valeur du paramètre d'état peut être la fréquence de résonance, la partie réelle, la partie imaginaire ou l'argument de l'impédance complexe.

L'exploitation de la partie réelle « Re(Z) = R+r(f) » permet par exemple de déterminer les caractéristiques physico-chimiques des électrodes et leur état de vieillissement.

L'exploitation de la partie imaginaire « Im(Z) = $Z_c \times coth(\gamma \times L)$ » permet par exemple de déterminer l'état de vieillissement ou la dégradation de l'électrolyte et de son interface avec les électrodes, ainsi que les micros courts-circuits. Les caractéristiques du séparateur imprégné d'électrolyte peuvent également être déterminées par l'analyse de cette partie imaginaire.

La dégradation des électrodes se manifeste par une élévation de la résistance r(f) de surface, cette résistance est mesurée à des fréquences dont les quarts des longueurs d'onde correspondent à la hauteur du faisceau électrochimique (fréquences correspondant à l'annulation de la partie imaginaire). Une fois la fréquence initialement déterminée, elle sera conservée constante pour ne pas intégrer de variation de la résistance en fonction de la fréquence.

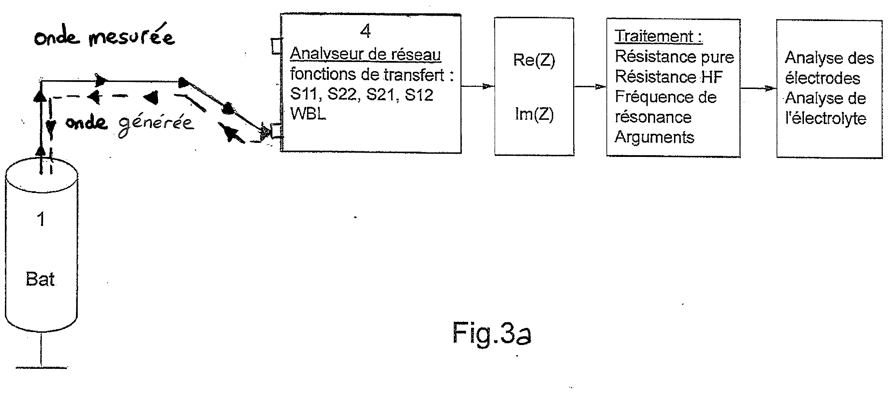

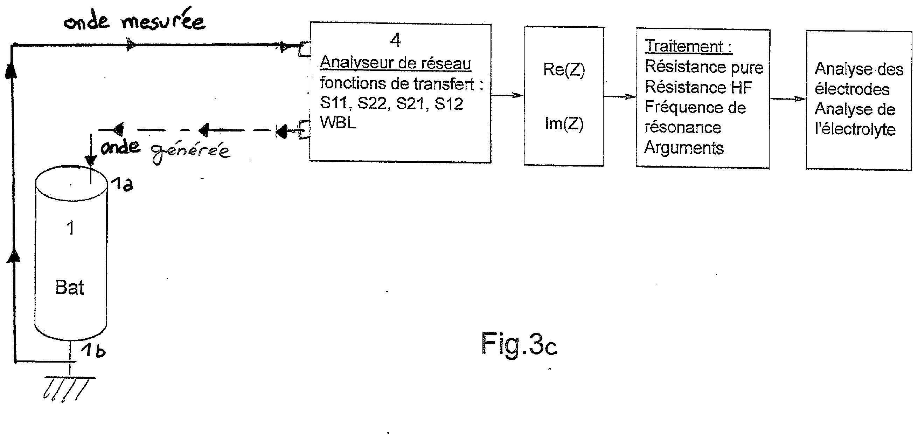

Un schéma de principe d'un dispositif de mesure de l'impédance est illustré aux figures 3a)-3d). La mesure d'impédance peut se faire soit dans le cas de la réflexion d'une onde électromagnétique (Fig.3a-3b), soit dans le cas de la transmission d'une onde électromagnétique (Fig.3c-3d). La mesure d'impédance peut se faire sans que l'élément électrochimique ne subisse de charge ou de décharge. Qu'il s'agisse d'une mesure de l'onde électromagnétique réfléchie ou transmise, l'élément électrochimique peut soit ne subir ni charge, ni décharge auquel cas il est dit en circuit ouvert, soit être traversé par un courant de charge ou de décharge, auquel cas l'élément est dit "sous courant". Le signal de l'onde électromagnétique est de fréquence élevée, de sorte que la caractérisation sous courant est possible car l'état de charge de l'élément électrochimique ne change pas en moins de 1 ms.

La figure 3a représente un schéma de principe de l'acquisition des mesures d'impédance dans le cas d'une réflexion d'une onde électromagnétique par le faisceau électrochimique, l'élément électrochimique (1) ne subissant ni charge, ni décharge (circuit ouvert). Un signal électromagnétique est généré à l'aide d'un analyseur de réseau (4) et est envoyé par l'intermédiaire d'un moyen de conduction du signal électromagnétique vers l'une des bornes de l'élément électrochimique. L'analyseur de réseau reçoit le signal formé par l'onde électromagnétique réfléchie par le faisceau électrochimique. La partie réelle et la partie imaginaire du signal sont mesurées à l'aide de l'analyseur de réseau dont l'impédance interne vaut classiquement 50Ω. L'analyseur de réseau permet de calculer les impédances complexes et les fonctions de transfert à l'aide des paramètres S : S11 et S22 pour la réflexion et S21 et S12 pour la transmission. Il permet également de déterminer la bande de fréquences pour la longueur du faisceau électrochimique déroulé (WBL) ainsi que la bande de fréquences pour la hauteur du faisceau électrochimique (WBH). L'exploitation de la partie réelle de l'impédance permet de déterminer la composante de résistance pure de l'impédance ainsi que la résistance haute fréquence. Ces valeurs de résistance permettent de détecter un vieillissement prématuré de l'élément ou une panne. L'exploitation de la partie imaginaire de l'impédance permet de déterminer les fréquences de résonance ainsi que les arguments qui permettent ensuite de détecter un vieillissement de l'électrolyte, la présence de micros courts-circuits ou un mauvais remplissage de l'électrolyte.

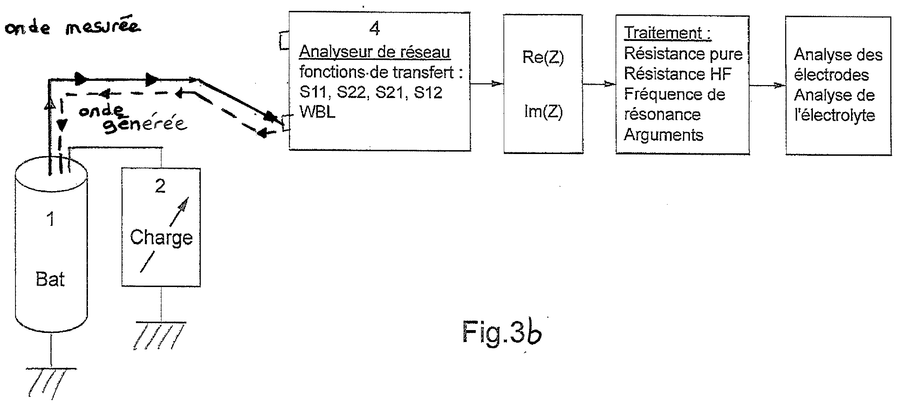

La figure 3b représente un schéma de principe de l'acquisition des mesures d'impédance dans le cas d'une réflexion d'une onde électromagnétique par le faisceau électrochimique, l'élément électrochimique étant traversé soit par un courant de charge soit par un courant de décharge (élément sous courant). Le dispositif de la figure 3b diffère de celui de la figure 3a en ce qu'il comprend une charge (2) délivrant à l'élément électrochimique (1) un signal permettant éventuellement de charger ou de décharger l'élément si on souhaite le caractériser en fonctionnement (caractérisation sous courant).

La figure 3c représente un schéma de principe de l'acquisition des mesures d'impédance dans le cas d'une transmission d'une onde électromagnétique par le faisceau électrochimique, l'élément électrochimique ne subissant ni charge, ni décharge (circuit ouvert). L'onde générée par l'analyseur de réseau est envoyée sur l'une des bornes (1a) de l'élément. L'onde transmise par le faisceau électrochimique est émise par la borne (1b) située sur le côté opposé du faisceau électrochimique. L'analyseur de réseau reçoit le signal formé par l'onde électromagnétique transmise par la borne située sur le côté opposé du faisceau électrochimique.

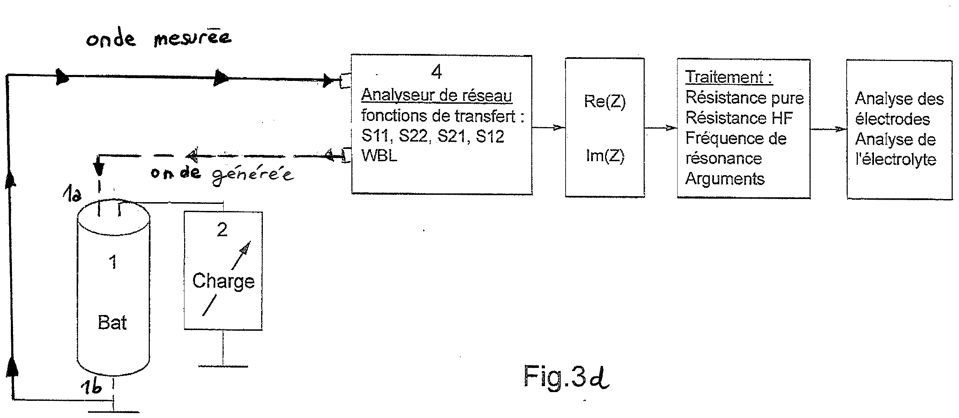

La figure 3d représente un schéma de principe de l'acquisition des mesures d'impédance dans le cas d'une transmission d'une onde électromagnétique par le faisceau électrochimique, l'élément électrochimique étant traversé soit par un courant de charge soit par un courant de décharge (élément sous courant). Le dispositif de la figure 3d diffère de celui de la figure 3c en ce qu'il comprend une charge (2) délivrant à l'élément électrochimique (1) un signal permettant éventuellement de charger ou de décharger l'élément si on souhaite le caractériser en fonctionnement (caractérisation sous courant).

Ce dispositif peut être mis en place à différents points de contrôle d'une chaine de fabrication de l'élément électrochimique afin de détecter un défaut. Il peut également être intégré dans un coffre comprenant une batterie d'éléments électrochimiques.

Selon l'invention, l'impédance complexe de l'élément électrochimique est mesurée en soumettant l'élément à une onde électromagnétique dont la fréquence appartient à une plage allant de 10 kHz à 10 GHz. Les impédances mesurées par cet équipement pourront être mesurées avec un élément électrochimique en circuit ouvert ou éventuellement débitant dans un circuit. Le courant pourra varier de quelques milliampères à plusieurs dizaines d'ampères. Comme expliqué ci-dessus, le signal de l'onde électromagnétique étant de fréquence élevée, la caractérisation sous courant est possible car l'état de charge de l'élément électrochimique ne change pas en moins de 1 ms.

L'exploitation de la fréquence de résonance $f_0$, qui est la fréquence à laquelle la partie imaginaire de l'impédance complexe devient nulle, fournit des informations sur la dimension du faisceau électrochimique. Sans vouloir être lié par la théorie, la Demanderesse est d'avis que les approximations suivantes sont significativement représentatives des phénomènes observés.

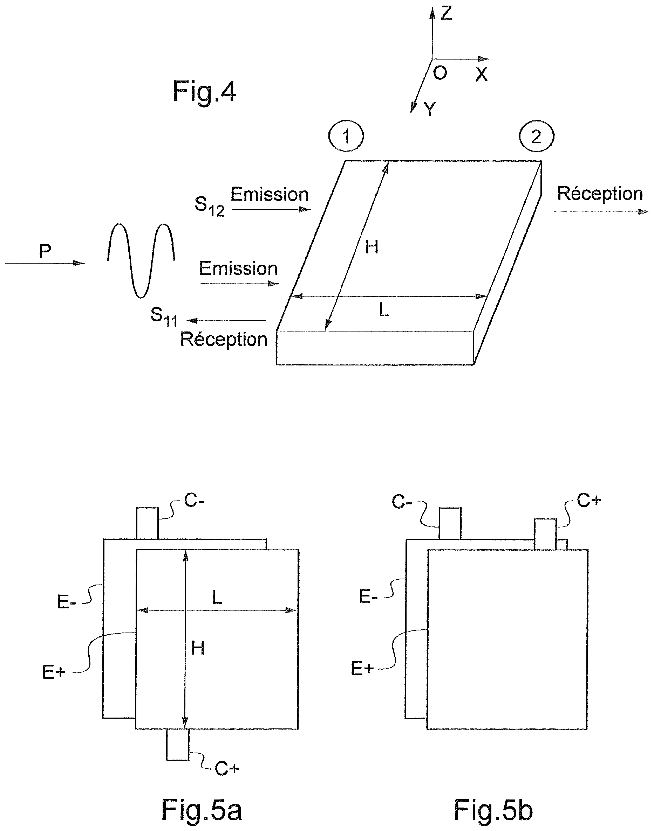

Soit une plaque plane de dimensions L, de hauteur H, de permittivité $\varepsilon r$, de perméabilité relative $\mu_r$ traversée dans le sens de sa longueur L par une onde électromagnétique selon la direction P, telle que représentée sur la figure 4. La propagation de l'onde électromagnétique dans la plaque plane fournit les fréquences de résonances caractéristiques suivantes en réflexion (S11) et en transmission (S12) :

$$f_0(L) = \frac{4c}{\sqrt{(\varepsilon_r \times \mu_r)} \times L} \quad (Hz)$$

$$f_0(H) = \frac{c}{2\sqrt{(\varepsilon_r \times \mu_r)} \times H} \quad (Hz)$$

où :

c est la vitesse de propagation d'une onde électromagnétique dans le vide, soit $3 \times 10^8$ m.s$^{-1}$ ; $\varepsilon_r$ est la permittivité relative moyenne du matériau dans lequel l'onde électromagnétique se propage ;

$\mu_r$ est la perméabilité relative moyenne du matériau dans lequel l'onde électromagnétique se propage et vaut 1.

S12 correspond à la fonction de transfert lorsque l'onde arrive sur le bord 1 de la plaque et est reçue sur le bord 2 de la plaque.

S11 correspond à la fonction de transfert lorsque l'onde arrive sur le bord 1 de la plaque et est reçue sur le même bord 1 de la plaque.

La propagation d'une onde électromagnétique dépend de son milieu de propagation, ou de conduction, mais également des zones de réflexion quelle peut rencontrer. La réflexion se produit selon l'axe z perpendiculaire à la direction P de propagation de l'onde.

Selon l'invention, on assimile le faisceau électrochimique à une plaque plane à travers laquelle se propage l'onde. Un faisceau électrochimique simplifié peut être constitué de deux plaques planes correspondant à une électrode positive et une électrode négative, lesquelles sont séparées par un séparateur imbibé d'élecrolyte. Des languettes métalliques constituant des collecteurs de sortie de courant sont présentes sur un bord de chaque plaque. Ces languettes peuvent être présentes soit sur des bords opposés pour les deux plaques, soit sur les mêmes bords pour les deux plaques. Ces deux configurations sont illustrées aux Figures 5a et 5b. L'ensemble est inséré dans une pochette flexible thermosoudable, non représentée, servant de conteneur. Ainsi se constitue un élément de type « sachet » (appelé « pouch cell » en anglais). L'empilement de faisceaux conduit à des éléments prismatiques qui peuvent bien sûr être analysés par la présente méthode.

On peut assimiler chaque élément de type « sachet » à une plaque plane de longueur L et de hauteur H et de permittivité relative $\varepsilon r$. La valeur de $\varepsilon r$ dépend des permittivités des collecteurs de courant, des masses électrochimiquement actives d'électrodes, de l'électrolyte et du séparateur. Chacune des variations d'un de ces composants peut entraîner une variation de $\varepsilon r$ et donc globalement de la fréquence de résonance $f_0$.

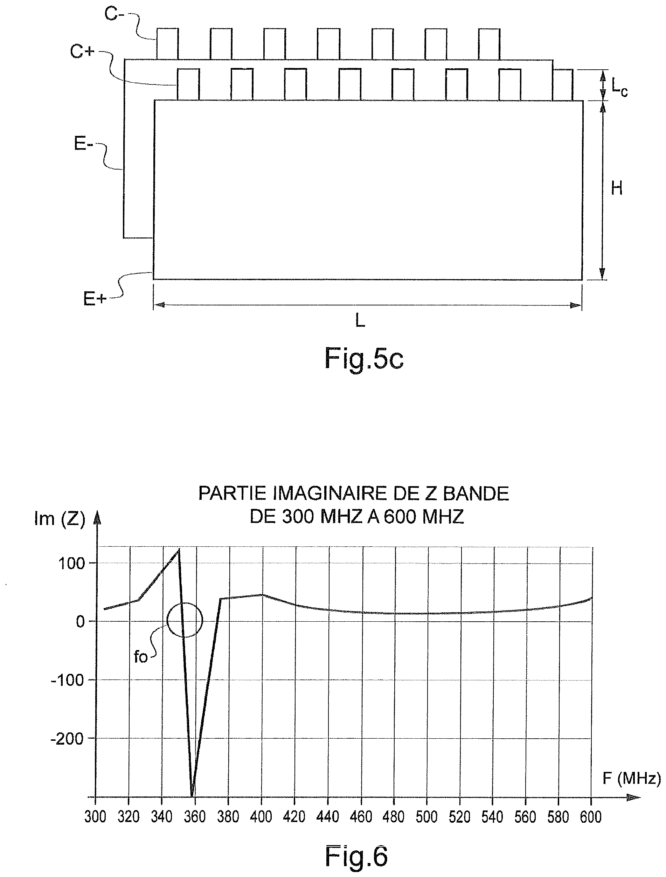

Dans l'hypothèse où les languettes des collecteurs de courant sont disposées sur le même bord des deux électrodes, on note alors une similitude entre la structure d'un faisceau électrochimique déroulé dans lequel les collecteurs de courant sont situés sur le même bord des deux électrodes (figure 5c) et la structure d'un élément sachet (figure 5b).

Une modification de l'élément électrochimique entraîne une modification de la permittivité relative $\varepsilon r$ et/ou des propriétés de réflexion du milieu traversé par l'onde électromagnétique et donc une déformation du signal. Bien que les différentes valeurs de permittivité relative soient connues pour les collecteurs de courant, les matières actives et l'électrolyte considérés individuellement, la valeur de permittivité globale du faisceau électrochimique ne peut pas être déterminée par un calcul théorique car l'assemblage constitué par le faisceau électrochimique forme un ensemble discontinu, inhomogène et poreux.

La réponse à une onde électromagnétique des différents états de l'élément peut être quantifiée par expérience, voire dans le futur par simulation. Des gabarits par exemple peuvent être utilisés pour s'assurer de l'état de l'élément, que ce soit en termes d'homogénéité de remplissage, de vieillissement, d'état de charge ou de courant de fuite par exemple. Certains de ces cas sont détaillés dans ce qui suit.

En assimilant un faisceau électrochimique à une plaque plane, on obtient une relation liant la fréquence de résonance $f_0(L)$ à la longueur L du feuillard métallique des électrodes (relation (I)) :

$$f_0(L) \approx \frac{4c}{\sqrt{(\varepsilon_r \times \mu_r)} \times k \times (L + Lc)} \quad (Hz) \qquad (I)$$

où :

c, $\varepsilon_r$, $\mu_r$ sont tels que définis précédemment ;

L est la longueur en mètres du feuillard métallique des électrodes, c'est-à-dire la longueur du faisceau électrochimique déroulé ;

$L_c$ est la longueur en mètres de la portion de feuillard métallique non recouverte de matière active. Cette portion non recouverte de matière active sert au soudage des connexions positives et négatives vers les bornes de sortie de courant respectives. Elle est généralement négligeable car très inférieure à L;

k est un facteur de correction dû à la spiralité du faisceau électrochimique et vaut environ 0,88.

La relation liant la fréquence de résonance à la hauteur du feuillard métallique des électrodes est (relation (II)):

$$f_0(H) \approx \frac{c}{2\sqrt{(\varepsilon_r \times \mu_r)} \times (H + L_c)} \quad (Hz) \qquad (II)$$

où :

c, $\varepsilon_r$, $\mu_r$ sont tels que définis précédemment ;
H est la largeur en mètres du feuillard métallique des électrodes, c'est-à-dire la hauteur du faisceau électrochimique ;
$L_c$ est telle que définie précédemment ;

La figure 6 représente la variation de la partie imaginaire de l'impédance complexe en fonction de la fréquence pour des fréquences de l'onde électromagnétique comprises entre 300 et 600 MHz pour un élément électrochimique de type lithium-ion. La courbe de la variation de la partie imaginaire en fonction de la fréquence présente un pic à une fréquence d'environ 360 MHz. Le cercle représenté sur la figure 6 montre qu'on peut déterminer la fréquence $f_0$ à laquelle la partie imaginaire de l'impédance devient nulle. Cette fréquence est comprise sur la figure entre 340 et 360 MHz. La déformation du pic par rapport au spectre obtenu sur un élément électrochimique considéré comme bon ou un changement de fréquences seront l'indication d'un changement d'état de l'élément par rapport à un élément calibré expérimentalement, voire par rapport à un modèle.

La validité du modèle établi par la Demanderesse est confirmée par les résultats de tests menés sur différents éléments électrochimiques de type lithium-ion de format cylindrique, comprenant tous une électrode négative à base de graphite, une électrode positive à base de $LiNiO_2$ et un électrolyte qui est un mélange de solvants carbonatés dans lequel $LiPF_6$ est dissous. Leur tension nominale est de 3,6V. Différentes capacités électrochimiques et différentes dimensions du faisceau électrochimique ont été testées. Le Tableau 1 indique les différentes capacités électrochimiques et les dimensions testées. Les Tableaux 1 et 2 indiquent les fréquences de résonance associées à chacun des éléments testés. La présence de deux fréquences de résonances $f_0$ relatives à la largeur et la longueur du faisceau électrochimique sont la validation de l'hypothèse selon laquelle le faisceau électrochimique peut être considéré comme une ligne de propagation d'une onde électromagnétique. On constate que la fréquence de résonance $f_0$ pour la longueur varie entre 120 et 176 MHz (Tableau 1) et la fréquence de résonance $f_0$ pour la hauteur varie entre 324 et 570 MHz (Tableau 2).

Tableau 1

|  | Ex.1 | Ex.2 | Ex.3 | Ex.4 | Ex.5 |
|---|---|---|---|---|---|
| Capacité électrochimique de l'élément (Ah) | 41 | 45 | 30 | 22 | 6 |
| Longueur réelle du feuillard (m) | 4,76 | 4 | 6 | 4,7 | 4,5 |
| Longueur $L_c$ de la languette de connexion (m) | 0,03 | 0,03 | 0,03 | 0,03 | 0,03 |
| Fréquence de résonance $f_0$ de la longueur du feuillard (MHz) | 152 | 176 | 120 | 152 | 159 |

La relation (I) appliquée à l'élément de l'exemple 1 du Tableau 1 donne la valeur L de la longueur du faisceau électrochimique suivante :

$$L = \frac{4c}{f_0 \times \sqrt{\varepsilon_r} \times k} - L_c = (\frac{4 \times 300}{152 \times \sqrt{3,5} \times 0,88}) - 0,03 = (4,795 - 0,030)\,m = 4,765\,m \approx 4,77\,m$$

La valeur de la longueur de 4,77 m obtenue par calcul est quasiment égale à la hauteur réelle de 4,76 m indiquée dans le Tableau 1.

Tableau 2

|  | Ex.1 | Ex.2 | Ex.3 | Ex.4 | Ex.5 |
|---|---|---|---|---|---|
| Hauteur H réelle du feuillard (m) | 0,222 | 0,222 | 0,222 | 0,106 | 0,106 |

(suite)

| | Ex.1 | Ex.2 | Ex.3 | Ex.4 | Ex.5 |
|---|---|---|---|---|---|
| Longueur $L_c$ de la languette de connexion (m) | 0,03 | 0,03 | 0,03 | 0,03 | 0,03 |
| Fréquence $f_0$ de résonance de la hauteur du feuillard (MHz) | 324 | 324 | 324 | 570 | 570 |

La relation (II) appliquée à l'élément de l'exemple 1 du Tableau 2 donne la valeur H de la hauteur du faisceau électrochimique suivante :

$$H = (\frac{c}{f_0 \times 2 \times \sqrt{\varepsilon_r}}) - L_c = (\frac{300}{324 \times 2 \times \sqrt{3,5}}) - 0,03 = (0,247 - 0,03)\,\mathrm{m} = 0,217\,\mathrm{m}$$

La valeur de la hauteur de 0,217 m obtenue par calcul est très voisine de la hauteur réelle de 0,222 m indiquée dans le Tableau 2.

Les relations (I) et (II) expriment la fréquence de résonance $f_0$ par rapport à la permittivité relative $\varepsilon r$. Elles montrent donc qu'une modification de la valeur de la permittivité relative du milieu de propagation de l'onde électromagnétique entraine une variation de la fréquence de résonance. La permittivité relative $\varepsilon_r$ varie par exemple suite à une modification de la composition de l'électrolyte, ou à une variation du degré d'imprégnation des électrodes ou encore à l'apparition de micro courts-circuits. Par conséquent, on observe une variation de la fréquence de résonance suite à une variation de la composition ou de l'homogénéité de l'électrolyte.

La méthode selon l'invention peut être utilisée comme moyen de contrôle pour détecter la présence de micros courts-circuits ou un mauvais remplissage de l'électrolyte sur une ligne de fabrication de l'élément électrochimique. Dans ce cas, on réalise dans un premier temps la mesure de l'impédance complexe sur un élément électrochimique, dit de référence, dont on connaît avec précision les paramètres physiques, c'est-à-dire, les dimensions des feuillards des électrodes, le volume et la composition de l'électrolyte, l'état du séparateur et le degré d'imprégnation du séparateur et des électrodes par l'électrolyte. Le tracé du spectre de la partie imaginaire de l'impédance complexe en fonction de la fréquence présente une fréquence de résonance de référence $f_{0R}$. Dans un second temps, on réalise la mesure de l'impédance complexe d'un élément électrochimique devant être contrôlé et on détermine la fréquence de résonance $f_0$. L'élément est considéré comme présentant un défaut si l'écart entre $f_{0R}$ et $f_0$ dépasse un certain seuil prédéterminé. Il est entendu que ce principe ne s'applique pas uniquement à la fréquence de résonance mais à tout autre indicateur tel que défini ci-avant.

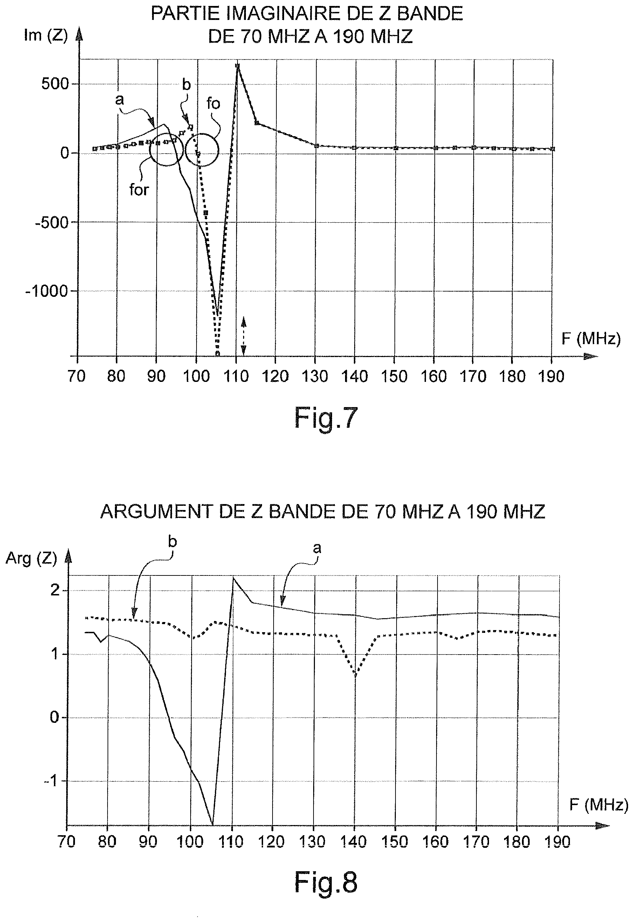

La figure 7 représente un exemple de superposition des tracés d'un premier spectre de référence réalisé sur un élément électrochimique de référence et d'un second spectre réalisé sur un élément électrochimique à tester. L'élément de référence et l'élément à tester sont tous les deux de type lithium-ion de format cylindrique et comprennent une électrode négative à base de graphite, une électrode positive à base de $LiNiO_2$ et un électrolyte qui est un mélange de solvants carbonatés dans lequel $LiPF_6$ est dissous.

L'élément de référence a) est un élément sur lequel on a réalisé la mesure d'impédance immédiatement après que celui-ci ait été rempli d'électrolyte. L'élément testé b) a subi une période de repos de 8 jours au cours de laquelle le degré d'imbibition (ou d'imprégnation) des électrodes et du séparateur par l'électrolyte a varié. En effet, un électrolyte tend à diffuser dans les pores du séparateur et les pores de la matière active. La permittivité relative de milieu traversé par l'onde électromagnétique varie donc suite à la modification du degré d'imbibition des électrodes et du séparateur. La variation de la valeur de permittivité entraine une variation de la fréquence de résonance. On constate en effet que pour une fréquence inférieure à environ 105 MHz, les fréquences de résonance diffèrent. La fréquence de résonance de référence $f_{0R}$ est d'environ 95 MHz pour l'élément de référence alors que la fréquence de résonance $f_0$ est d'environ 100 MHz pour l'élément testé. Cette différence entre les fréquences traduit une évolution de l'électrolyte au cours du temps. La méthode selon l'invention permet par exemple de déterminer le temps de repos nécessaire pour obtenir une imprégnation optimale des électrodes et du séparateur.

Le tracé de la variation de l'argument permet de suivre l'évolution de l'élément électrochimique après que celui-ci ait subi les premiers cycles de charge/décharge nécessaires à ce qu'il atteigne sa capacité maximale (étape encore appelée « formation électrochimique de l'élément »). Généralement, on trace la variation de l'argument pour une fréquence allant de 10 à 1000 MHz, de préférence entre 50 et 200 MHz.

A titre d'exemple, la figure 8 représente l'argument d'un élément après formation électrochimique a) et son évolution b) après quelques jours pour une fréquence allant de 70 à 190 MHz. On constate que juste après formation, l'argument présente un pic à 105 MHz d'une amplitude d'environ 2,5. Ce pic disparait après que l'élément électrochimique ait été mis au repos quelques jours.

**EP 2 607 911 B1**

Le tracé de la variation de la partie imaginaire et de la partie réelle ainsi que de l'argument permet de suivre le vieillissement du faisceau électrochimique ou le degré d'autodécharge. Généralement, on trace la variation de l'argument pour une fréquence allant de 0,01 à 10 MHz, de préférence allant de 0,1 et 1 MHz.

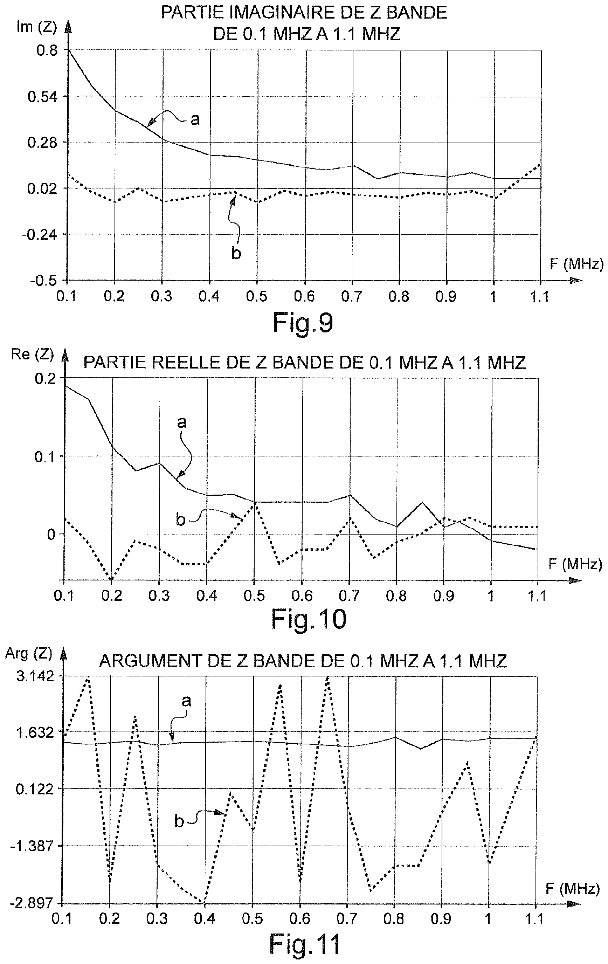

Les figures 9, 10 et 11 représentent respectivement la partie imaginaire, la partie réelle et l'argument de l'impédance de deux éléments électrochimiques de type lithium-ion caractérisés par des taux d'autodécharge différents. Pour chacune des figures 9 à 11, on constate que le spectre de l'élément présentant le taux d'autodécharge le plus élevé b) présente des brusques variations d'ordonnées. La figure 11 montre des variations de l'argument allant jusqu'à environ 3 à 4 unités pour l'élément présentant la plus forte autodécharge alors que l'argument pour l'élément présentant la plus faible autodécharge ne varie quasiment pas et vaut environ 1,5. Les fortes variations de l'argument traduisent une autodécharge significative de l'élément électrochimique.

Un critère sur la hauteur du pic peut être choisi pour être utilisé pour décider si le vieillissement de l'élément a atteint un seuil prédéterminé. Par exemple, si le spectre présente un pic tel que la différence entre l'ordonnée du point au sommet du pic et la valeur maximale des ordonnées des deux points situés à la base du pic divisée par l'ordonnée du point au sommet du pic est supérieure à une certaine valeur prédéterminée, alors le vieillissement peut être considéré comme significatif.

Un des avantages de la méthode est qu'elle permet de déterminer l'origine d'une anomalie dans un élément électrochimique. Elle permet de suivre l'évolution de l'état d'un élément électrochimique en sortie de chaine de fabrication et de déterminer le temps de repos permettant d'obtenir une imprégnation optimale du séparateur et des électrodes par l'électrolyte. La méthode permet de détecter d'éventuelles disparités d'épaisseur de l'électrolyte, des défauts de remplissage. Un avantage supplémentaire de la méthode est que les mesures sont réalisées à haute fréquence, ce qui permet de réduire le temps d'analyse par rapport à une mesure d'impédance réalisée dans une gamme de fréquence inférieure. La méthode selon l'invention peut constituer un outil de contrôle qualité en permettant de suivre une éventuelle dérive dans le procédé de fabrication d'éléments électrochimiques. Des mesures d'impédances ont été réalisées sur deux éléments électrochimiques prélevés à la fin du procédé de fabrication. L'un des éléments est conforme au cahier des charges et sert de référence : il s'agit de l'exemple 1 des Tableaux 1 et 2. L'autre élément est non conforme au cahier des charges : il s'agit de l'exemple 6.

Tableau 3

|  | Fréquence de résonance pour la longueur du faisceau électrochimique (MHz) | Fréquence de résonance pour la hauteur du faisceau électrochimique (MHz) |
|---|---|---|
| Exemple 1 : Elément électrochimique conforme | 152 | 324 |
| Exemple 6 : Element électrochimique non conforme | 145 | 403 |

L'élément non conforme de l'exemple 6 présente des fréquences de résonance différentes de celles de l'élément conforme. La variation de fréquence représente 5% pour la fréquence de résonance pour la longueur et 25% pour la fréquence de résonance pour la hauteur. La méthode selon l'invention peut donc servir de méthode de contrôle d'éléments électrochimiques dans une ligne de fabrication afin de suivre l'évolution des éléments électrochimiques produits.

**Revendications**

1.   Méthode de détermination d'un indicateur de la valeur d'un paramètre d'état d'un élément électrochimique (1) comprenant un faisceau électrochimique (F), lequel faisceau est constitué par un assemblage d'électrodes positives (E+) et d'électrodes négatives (E-) avec un séparateur (S) intercalé entre une électrode positive et une électrode négative,
ladite méthode étant **caractérisée en ce qu'**elle comprend les étapes suivantes:

a) la génération par un analyseur de réseau d'une onde électromagnétique dont la fréquence va de 10 kHz à 10 GHz,
b) l'envoi de l'onde électromagnétique par l'intermédiaire d'un moyen de conduction de l'onde électromagnétique vers l'une des bornes de l'élément électrochimique ;
c) la réception du signal formé par l'onde électromagnétique réfléchie ou transmise par le faisceau électrochimique ;

d) le calcul par l'analyseur de réseau (4) de l'impédance complexe (Z) de l'élément électrochimique traversé par l'onde électromagnétique ;

e) l'analyse d'au moins une partie du spectre d'impédance complexe de l'élément électrochimique à la sollicitation par l'onde électromagnétique, de manière à déterminer un indicateur de la valeur dudit paramètre d'état, lequel indicateur est choisi parmi la fréquence de résonance du spectre d'impédance complexe $f_0$, la partie réelle de l'impédance complexe Re(Z), la partie imaginaire de l'impédance complexe Im(Z) et l'argument de l'impédance complexe Arg(Z).

2. Méthode selon la revendication 1, dans laquelle la fréquence va de 100 kHz à 10 GHz, de préférence de 1 MHz à 1 GHz, de préférence encore de 10 MHz à 1 GHz.

3. Méthode selon la revendication 1 ou 2, comprenant en outre l'étape f) de détermination de la valeur dudit paramètre d'état à partir de l'indicateur de la valeur dudit paramètre d'état obtenu à l'étape e) et la valeur du paramètre d'état est comparée à une valeur de référence et l'élément électrochimique est considéré comme présentant un défaut si l'écart entre la valeur du paramètre d'état et la valeur de référence dépasse un seuil prédéterminé.

4. Méthode comprenant :

   - la réalisation des étapes a) à e) de la méthode selon l'une des revendications 1 à 2 sur un élément électrochimique de référence de manière à déterminer un indicateur de référence de la valeur d'un paramètre d'état ledit élément électrochimique de référence comprenant un faisceau électrochimique, lequel faisceau est constitué par un assemblage d'électrodes positives et d'électrodes négatives avec un séparateur intercalé entre une électrode positive et une électrode négative,
   - la réalisation de la méthode selon l'une des revendications 1 à 2 de manière à déterminer un indicateur de la valeur d'un paramètre d'état,
   - la comparaison du tracé de la variation de l'indicateur de la valeur du paramètre d'état de l'élément électrochimique avec le tracé de la variation de l'indicateur de référence de la valeur du paramètre d'état.

5. Méthode selon la revendication 4, dans laquelle le paramètre d'état est un paramètre qui varie au cours de l'utilisation de l'élément électrochimique, tel que sa capacité, sa résistance interne, son état de charge, l'état de vieillissement des électrodes, l'état de vieillissement de l'électrolyte ou l'état de vieillissement du séparateur.

6. Méthode selon l'une des revendications 1 à 5, comprenant les étapes de :

   - tracé du spectre d'impédance complexe du faisceau électrochimique et
   - détermination d'au moins une fréquence de résonance $f_0$ du spectre d'impédance complexe, qui est une fréquence à laquelle la partie imaginaire de l'impédance complexe est nulle.

7. Méthode selon la revendication 6, dans laquelle le spectre d'impédance complexe du faisceau électrochimique est tracé pour une plage de fréquences comprises entre 200 MHz et 1GHz, de préférence entre 300 MHz et 600 MHz et dans laquelle plage, il existe au moins une fréquence de résonance $f_0$, de manière à déterminer le paramètre d'état correspondant à la hauteur (H) du faisceau électrochimique (F), la hauteur du faisceau électrochimique étant égale à la hauteur du feuillard utilisé pour les électrodes positive et négative, la hauteur du feuillard étant définie comme la plus petite dimension de ce feuillard située dans le plan formé par le feuillard lorsque celui-ci est déroulé.

8. Méthode selon la revendication 6, dans laquelle le spectre d'impédance complexe du faisceau électrochimique est tracé pour une plage de fréquences comprises entre 10 MHz et 200 MHz, de préférence entre 50 MHz et 200 MHz et dans laquelle plage, il existe au moins une fréquence de résonance $f_0$, de manière à déterminer le paramètre d'état correspondant à la longueur (L) du faisceau électrochimique (F) déroulé.

9. Méthode selon l'une des revendications précédentes, dans laquelle :

   - on trace la variation pour une fréquence allant de 0,1 MHz à 1 MHz, d'au moins l'un des indicateurs choisis parmi la partie réelle de l'impédance complexe, la partie imaginaire de l'impédance complexe ou une combinaison de celles-ci, telle que l'argument de l'impédance complexe, de manière à déterminer un paramètre d'état, de préférence le vieillissement de l'élément électrochimique.

10. Méthode selon la revendication 9, dans laquelle le vieillissement de l'élément électrochimique est considéré comme significatif si, quand on représente la variation de la partie réelle de l'impédance complexe en fonction de la fréquence, il existe au moins un pic tel que le rapport :

$$(Remax - Max\ (Re1, Re2))/Remax$$

soit supérieur à 0,5, de préférence supérieur à 0,75
où

Remax représente la partie réelle au sommet du pic ;
Re1 et Re2 désignent les parties réelles aux deux bases du pic ; et
Max (Re1, Re2) représente la valeur maximum de Re1 et Re2.

11. Méthode selon la revendication 9, dans laquelle le vieillissement de l'élément électrochimique est considéré comme significatif si, quand on représente la variation de la partie imaginaire de l'impédance complexe en fonction de la fréquence, il existe au moins un pic tel que le rapport:

$$(Immax - Max\ (Im1, Im2))/Immax$$

soit supérieur à 0,5, de préférence supérieur à 0,75
où

Immax représente la partie imaginaire au sommet du pic ;
Im1 et Im2 désignent les parties imaginaires aux deux bases du pic ; et
Max(Im1, Im2) représente la valeur maximum de Im1 et Im2.

12. Méthode selon l'une des revendications précédentes, dans laquelle l'élément électrochimique est au lithium, de préférence de type lithium-ion.

13. Méthode de contrôle de la fabrication d'éléments électrochimiques, mettant en œuvre la méthode selon l'une quelconque des revendications 4 à 12, dans laquelle :

- on mesure sur chaque élément fabriqué un indicateur de la valeur du paramètre d'état ;
- on rejette un élément lorsque l'écart entre l'indicateur de la valeur du paramètre d'état mesurée et l'indicateur de référence de la valeur du paramètre d'état excède un seuil prédéterminé.

14. Méthode de contrôle selon la revendication 13, comprenant un prélèvement statistique d'éléments électrochimiques dans une ligne de fabrication afin de suivre l'évolution des éléments électrochimiques produits.

**Patentansprüche**

1. Methode zur Bestimmung eines Indikators des Werts eines Zustandsparameters eines elektrochemischen Elements (1), umfassend einen elektrochemischen Strahl (F), wobei der Strahl aus einer Anordnung positiver Elektroden (E+) und negativer Elektroden (E-) besteht, wobei ein Teiler (S) zwischen einer positiven Elektrode und einer negativen Elektrode angeordnet ist, wobei die genannte Methode **dadurch gekennzeichnet ist, dass** sie die folgenden Schritte umfasst:

a) Generieren einer elektromagnetischen Welle durch einen Netzanalysator, deren Frequenz von 10 kHz bis 10 GHz beträgt,
b) Senden der elektromagnetischen Welle mit Hilfe eines Mittels zum Leiten der elektromagnetischen Welle zu einer der Klemmen des elektrochemischen Elements;
c) Empfangen des Signals, das von der elektromagnetischen Welle gebildet wird, die reflektiert oder durch den elektrochemischen Strahl übertragen wird;
d) Berechnen der komplexen Impedanz (Z) des elektrochemischen Elements, das von der elektromagnetischen Welle durchquert wird, durch den Netzanalysator (4);
e) Analysieren mindestens eines Teils des komplexen Impedanzspektrums des elektrochemischen Elements gemäß der elektromagnetischen Welle, um einen Indikator des Werts des genannten Zustandsparameters zu bestimmen, wobei der Indikator aus der Resonanzfrequenz $f_0$ des komplexen Impedanzspektrums, dem realen Teil Re(Z) der komplexen Impedanz, dem imaginären Teil Im(Z) der komplexen Impedanz und dem Argument Arg(Z) der komplexen Impedanz ausgewählt wird.

2. Methode nach Anspruch 1, wobei die Frequenz von 100 kHz bis 10 GHz, vorzugsweise von 1 MHz bis 1 GHz, noch bevorzugter von 10 MHz bis 1 GHz beträgt.

3. Methode nach Anspruch 1 oder 2, ferner umfassend den Schritt f) des Bestimmens des Werts des genannten Zustandsparameters aus dem Indikator des Werts des genannten Zustandsparameters, der in dem Schritt e) erhalten wird, und wobei der Wert des Zustandsparameters mit einem Referenzwert verglichen wird, und das elektrochemische Element als fehlerhaft angesehen wird, wenn die Abweichung zwischen dem Wert des Zustandsparameters und dem Referenzwert eine vorherbestimmte Schwelle überschreitet.

4. Methode, umfassend:

   - Durchführen der Schritte a) bis e) der Methode nach einem der Ansprüche 1 bis 2 an einem elektrochemischen Referenzelement, um einen Referenzindikator des Werts eines Zustandsparameters zu bestimmen, wobei das genannte elektrochemische Referenzelement einen elektrochemischen Strahl umfasst, wobei der Strahl aus einer Anordnung positiver Elektroden und negativer Elektroden besteht, wobei ein Teiler zwischen einer positiven Elektrode und einer negativen Elektrode angeordnet ist,
   - Durchführen der Methode nach einem der Ansprüche 1 bis 2, um einen Indikator des Werts eines Zustandsparameters zu bestimmen,
   - Vergleichen des Verlaufs der Variation des Indikators des Werts des Zustandsparameters des elektrochemischen Elements mit dem Verlauf der Variation des Referenzindikators des Werts des Zustandsparameters.

5. Methode nach Anspruch 4, wobei der Zustandsparameter ein Parameter ist, der während der Verwendung des elektrochemischen Elements variiert, wie seine Kapazität, sein Innenwiderstand, sein Ladungszustand, der Alterungszustand der Elektroden, der Alterungszustand des Elektrolyten oder der Alterungszustand des Teilers.

6. Methode nach einem der Ansprüche 1 bis 5, umfassend die Schritte:

   - Verfolgen des komplexen Impedanzspektrums des elektrochemischen Strahls, und
   - Bestimmen mindestens einer Resonanzfrequenz $f_0$ des komplexen Impedanzspektrums, die eine Frequenz ist, bei welcher der imaginäre Teil der komplexen Impedanz Null ist.

7. Methode nach Anspruch 6, wobei das komplexe Impedanzspektrum des elektrochemischen Strahls für einen Frequenzbereich zwischen 200 MHz und 1 GHz, vorzugsweise zwischen 300 MHz und 600 MHz, verfolgt wird, und in welchem Bereich mindestens eine Resonanzfrequenz $f_0$ vorliegt, um den Zustandsparameter entsprechend der Höhe (H) des elektrochemischen Strahls (F) zu bestimmen, wobei die Höhe des elektrochemischen Strahls gleich ist der Höhe des Streifens, der für die positive und negative Elektrode verwendet wird, wobei die Höhe des Streifens als kleinste Abmessung dieses Streifens definiert wird, welche in der Ebene angeordnet ist, die von dem Streifen gebildet wird, wenn dieser ausgerollt wird.

8. Methode nach Anspruch 6, wobei das komplexe Impedanzspektrum des elektrochemischen Strahls für einen Frequenzbereich zwischen 10 MHz und 200 MHz, vorzugsweise zwischen 50 MHz und 200 MHz, verfolgt wird, und in welchem Bereich mindestens eine Resonanzfrequenz $f_0$ vorliegt, um den Zustandsparameter entsprechend der Länge (L) des ausgerollten elektrochemischen Strahls (F) zu bestimmen.

9. Methode nach einem der vorhergehenden Ansprüche, wobei:

   - die Variation für eine Frequenz von 0,1 MHz bis 1 MHz mindestens eines der Indikatoren verfolgt wird, die aus dem realen Teil der komplexen Impedanz, dem imaginären Teil der komplexen Impedanz oder einer Kombination derselben ausgewählt werden, wie dem Argument der komplexen Impedanz, um einen Zustandsparameter, vorzugsweise die Alterung des elektrochemischen Elements, zu bestimmen.

10. Methode nach Anspruch 9, wobei die Alterung des elektrochemischen Elements als signifikant angesehen wird, wenn, sobald die Variation des realen Teils der komplexen Impedanz als Funktion der Frequenz dargestellt wird, mindestens ein Peak vorliegt, so dass das Verhältnis:

$$(Remax - Max (Re1, Re2))/Remax$$

größer ist als 0,5, vorzugsweise größer als 0,75, wobei

Remax den realen Teil am Gipfel des Peaks darstellt;
Re1 und Re2 die realen Teile an den beiden Basen des Peaks bezeichnen; und
Max (Re1, Re2) den Maximalwert von Re1 und Re2 darstellt.

11. Methode nach Anspruch 9, wobei die Alterung des elektrochemischen Elements als signifikant angesehen wird, wenn, sobald die Variation des imaginären Teils der komplexen Impedanz als Funktion der Frequenz dargestellt wird, mindestens ein Peak vorliegt, so dass das Verhältnis:

$$(Immax - Max (Im1, Im2))/Immax$$

größer ist als 0,5, vorzugsweise größer als 0,75, wobei

Immax den imaginären Teil am Gipfel des Peaks darstellt;
Im1 und Im2 die imaginären Teile an den beiden Basen des Peaks bezeichnen; und
Max (Im1, Im2) den Maximalwert von Im1 und Im2 darstellt.

12. Methode nach einem der vorhergehenden Ansprüche, wobei das elektrochemische Element lithiumhaltig ist, vorzugsweise vom Typ Lithiumionen.

13. Methode zum Steuern der Herstellung von elektrochemischen Elementen, wobei die Methode nach einem der Ansprüche 4 bis 12 verwendet wird, wobei:

- an jedem hergestellten Element ein Indikator des Werts des Zustandsparameters gemessen wird;
- ein Element verworfen wird, wenn die Abweichung zwischen dem Indikator des gemessenen Werts des Zustandsparameters und dem Referenzindikator des Werts des Zustandsparameters eine vorherbestimmte Schwelle überschreitet.

14. Steuermethode nach Anspruch 13, umfassend eine statistische Erhebung elektrochemischer Elemente in einer Herstellungslinie, um die Entwicklung der erzeugten elektrochemischen Elemente zu verfolgen.

**Claims**

1. A method for determining a parameter of a state of an electrochemical cell (1) comprising an electrode plate group (F), said electrode plate group being constituted by an assembly of positive electrodes (E+) and negative electrodes (E-), with a separator (S) being interleaved between a positive electrode and a negative electrode, said. method being **characterized in that** it comprises the following steps:

a) generating, using a network analyzer, an electromagnetic wave in a frequency ranging from 10 kHz to 10 GHz,
b) sending the electromagnetic wave through a means for conducting an electromagnetic wave to one terminal of the electrochemical cell
c) receiving the signal constituted by the electromagnetic wave reflected or transmitted by the electrode plate group;
d) calculating, using the network analyzer (4) the complex impedance (Z) of the electrochemical cell through which the electromagnetic wave is passing;
e) analyzing at least a portion of a complex impedance spectrum of the electrochemical cell upon application of the electromagnetic wave so as to determine an indicator of the value of said state parameter, said indicator being chosen from the resonance frequency $f_0$ of the complex impedance spectrum, the real part Re(Z) of the complex impedance, the imaginary part Im(Z) of the complex impedance and the argument of the complex impedance Arg(Z).

2. The method according to claim 1, wherein the frequency ranges from 100 kHz to 10 GHz, preferably between 1 MHz to 1 GHz, more preferably between 10 MHz to 1 GHz.

3. The method according to claim 1 or 2, further comprising a step f) of determining the value of the state parameter from an indicator of said state parameter obtained at step e) and the value of the state parameter is compared with a reference value and the electrochemical cell is considered to be defective if a difference between the value of the state parameter and the reference value exceeds a predetermined threshold.

4. The method according to one of claims 1 or 2, comprising

   - performing the steps a) to e) of claims 1 or 2 on a reference cell so as to determine a reference indicator of the value of a state parameter, said reference cell comprising an electrode plate group, said electrode plate group being constituted by an assembly of positive electrodes and negative electrodes, with a separator being interleaved between a positive electrode and a negative electrode,
   - performing the method of one of claims 1 or 2 so as to determine a reference indicator of the value of a state parameter;
   - comparing a plot of variation of an indicator value of the state parameter for a cell with a plot of the change of the reference indicator for the value of the state parameter.

5. The method according to claim 4, wherein the state parameter is a parameter which varies during use of the electrochemical cell, such as its capacity, internal resistance, its state of charge, the state of aging of its electrodes, the state of aging of the electrolyte or the state of aging of the separator.

6. The method according to one of claims 1 to 5, comprising the steps of:

   - plotting a complex impedance spectrum of the electrode plate group, and
   - determining at least one resonance frequency $f_0$ of the complex impedance spectrum which is a frequency at which the imaginary part of the complex impedance is zero.

7. The method according to claim 6, wherein the complex impedance spectrum of the electrode plate group is plotted for a range of frequencies between 200 MHz and 1GHz, preferably between 300 MHz and 600 MHz and wherein within said range at least one resonance frequency $f_0$ exists, in order to determine the state parameter corresponding to the height (H) of the electrode plate group (F), the height of the electrode plate group being equal to the height of a strip used for the positive and negative electrodes, the height of a strip being defined as the smallest dimension of the strip in the plane formed by the strip when it is an unwound state.

8. The method according to claim 6, wherein the complex impedance spectrum of the electrode plate group is plotted for a range of frequencies between 10 MHz and 200 MHz, preferably between 50 MHz to 200 MHz and wherein within the said range at least one resonance frequency $f_0$ exists, in order to determine the state parameter corresponding to the length (L) of the unwound electrode plate group (F).

9. The method according to one of the preceding claims, comprising the steps of:

   - plotting variation for a frequency ranging from 0.01 MHz to 10 MHz, preferably between 0.1 MHz to 1 MHz, of at least one indicator selected from the real part of the complex impedance, the imaginary part of the complex impedance or a combination of these, such as the argument of the complex impedance, so as to determine a state parameter, preferably aging of the electrochemical cell.

10. The method according to claim 9, wherein variation in the real part of the complex impedance as a function of frequency is represented and at least one peak exists such that a ratio:

$$(Remax - Max (Re1, Re2)) / Remax$$

is greater than 0.5, preferably greater than 0.75
where

   Remax denotes the real part at the peak;

Re1 and Re2 denote the real parts of both bases at the peak, and
Max (Re1, Re2) denotes the maximum value of Re1 and Re2.

11. The method according to claim 9, wherein variation in the imaginary part of the complex impedance is represented as a function of frequency and at least one peak exists such that a ratio:

$$(\text{Immax} - \text{Max (Im1, Im2)}) / \text{Immax}$$

is greater than 0.5, preferably greater than 0.75
where

Immax denotes the imaginary part at the peak;
Im1 and Im2 denote the imaginary parts at the two bases at the peak, and
Max (Im1, Im2) represents a maximum value of Im1 and Im2.

12. The method according to one of the preceding claims, wherein the electrochemical cell is a lithium cell, preferably a cell of the lithium-ion type.

13. A method of monitoring the manufacture of electrochemical cells, implementing the method according to any one of claims 4 to 12, wherein:

- the value of an indicator of the state parameter is measured on each cell manufactured;
- a cell is rejected if the difference between the indicator of the value of the state parameter measured and the reference indicator of the value of the state parameter exceeds a predetermined threshold.

14. The monitoring method according to claim 13, comprising statistical sampling of electrochemical cells on a production line in order to monitor changes in the cells produced.

Fig.1

Fig.2

Fig.3a

onde mesurée

onde générée

Bat

1

4
Analyseur de réseau
fonctions de transfert :
S11, S22, S21, S12
WBL

Re(Z)

Im(Z)

Traitement :
Résistance pure
Résistance HF
Fréquence de
résonance
Arguments

Analyse des
électrodes
Analyse de
l'électrolyte

onde mesurée

onde générée

1
Bat

2
Charge

4
Analyseur de réseau
fonctions de transfert :
S11, S22, S21, S12
WBL

Re(Z)

Im(Z)

Traitement :
Résistance pure
Résistance HF
Fréquence de
résonance
Arguments

Analyse des
électrodes
Analyse de
l'électrolyte

Fig.3b

onde mesurée

| onde générée | 4<br>**Analyseur de réseau**<br>fonctions de transfert :<br>S11, S22, S21, S12<br>WBL | Re(Z)<br><br>Im(Z) | **Traitement :**<br>Résistance pure<br>Résistance HF<br>Fréquence de<br>résonance<br>Arguments | Analyse des<br>électrodes<br>Analyse de<br>l'électrolyte |

1a

1

Bat

1b

Fig.3c

onde mesurée

**4**
Analyseur de réseau
fonctions de transfert :
S11, S22, S21, S12
WBL

onde générée

Re(Z)

Im(Z)

Traitement :
Résistance pure
Résistance HF
Fréquence de
résonance
Arguments

Analyse des
électrodes
Analyse de
l'électrolyte

1a

1

Bat

1b

2

Charge

Fig.3d

# Fig.4

# Fig.5a          Fig.5b

Fig.5c

PARTIE IMAGINAIRE DE Z BANDE
DE 300 MHZ A 600 MHZ

Fig.6

PARTIE IMAGINAIRE DE Z BANDE
DE 70 MHZ A 190 MHZ

Fig.7

ARGUMENT DE Z BANDE DE 70 MHZ A 190 MHZ

Fig.8

PARTIE IMAGINAIRE DE Z BANDE
DE 0.1 MHZ A 1.1 MHZ

Fig.9

PARTIE REELLE DE Z BANDE DE 0.1 MHZ A 1.1 MHZ

Fig.10

ARGUMENT DE Z BANDE DE 0.1 MHZ A 1.1 MHZ

Fig.11

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- Symmetrical electrode mode for PEMFC characterisation using impedance spectroscopy. **HOMBRADOS A G et al.** JOURNAL OF POWER SOURCES. ELSEVIER, 10 Octobre 2005, vol. 151, 25-31